# EUROPEAN PATENT APPLICATION

(11) **EP 2 557 642 A2**
(43) Date of publication of application: **13.02.2013**
(21) Application number: 12179414.3
(22) Date of filing: 06.08.2012
(51) Int. Cl.: H01S 5/022, H01S 5/028, G02B 27/00, H01S 5/00

(54) **Optical component and optical module**

(30) Priority: 11.08.2011 JP 2011176301
(71) Applicant: Sharp Kabushiki Kaisha, Osaka-shi, Osaka 545-8522 (JP)
(72) Inventor: Kawakami, Toshiyuki, Osaka-shi, Osaka 545-8522 (JP); Kamikawa, Takeshi, Osaka-shi, Osaka 545-8522 (JP)
(74) Representative: Treeby, Philip David William

(57) **Abstract**

An optical component emits or transmits laser light of a wavelength of 460 nm or less. A first coating (A) formed from a dielectric film like SiO2 is applied upon at least a part of the surface thereof as an AR coating, and a second coating (B) formed from a dielectric film containing a noble metal or platinum group element is applied upon the first coating (A) to prevent contamination of the surface of the optical component. A laser diode (10) in a housing (70) with a window (20) may have said contamination preventing coating (B) on the light emitting surface and the outside of the window (20).

## Description

### BACKGROUND OF THE INVENTION

### 1. Field of the Invention

The present invention relates to a coating for an optical component for emitting and transmitting short-wavelength laser light.

### 2. Description of Related Art

In recent years, from considerations of directionality and reduced energy consumption, the use of light-emitting diode (LED) elements, semiconductor laser elements, and the like as various light sources has drawn attention. For example, nitride semiconductor laser elements show much promise as excitation light sources for phosphors due to their short oscillation wavelengths; and by irradiating phosphors with light of a wavelength in the region from blue to near ultraviolet, the light can be converted to the three primary colors and used. In particular, the use of short-wavelength, high-output laser light produced by nitride semiconductor lasers shows promise as a next-generation light source for use in projectors, televisions, and the like.

However, a known problem in laser modules, which are formed from a semiconductor laser element, a collimator lens, a condenser lens, an optical fiber, and the like sealed within a closed container, is that residual contaminants within the closed container adhere to the emitting facets of semiconductor laser elements or to optical components such as lenses and optical fibers, degrading the properties of the laser. Examples of contaminants include hydrocarbon compounds, silicon compounds, or the like present in the operating atmosphere, which compounds can be polymerized or broken down the laser light and heat, and caused to adhere.

Various methods have been proposed hitherto in order to solve this problem. For example, Japanese Laid-open Patent Application No. H11-167132 teaches that reducing the amount of hydrocarbon compounds in the environment to 0.1% or less is effective in preventing reductions in output of laser light of 400 nm or less, and that the deposition of hydrocarbon compounds upon optical components or the like as a result of photolysis can be thereby prevented.

U.S. Patent No. 5392305 describes mixing 100 ppm or more of oxygen into atmospheric gases with the goal of breaking down hydrocarbon gases in order to prevent the adherence of hydrocarbon compounds to the facet of a semiconductor laser element as a result of the photolysis of these gases.

Japanese Laid-open Patent Application No. 2004-14820 describes disposing a substance having a gas adsorption function within the closed container in order to prevent the adherence, not only of hydrocarbon compounds, but also of organic silicon compounds derived from siloxanes or the like.

Japanese Laid-open Patent Application No. 2009-21548 describes an effect of noble metals or platinum group metals such as palladium in suppressing the adherence of silicon compounds, albeit the mechanism thereof is unclear.

Japanese Laid-open Patent Application No. 2004-179595 teaches applying a photocatalytic layer coating, activated by light emitted from a semiconductor laser, to at least one of an inner wall of a semiconductor laser module, a light passing area of a semiconductor laser module, a light-entrance end of an optical fiber, or a light-exit end of an optical fiber.

However, because the existing technologies described above constitute solutions applied in the case of a sealed atmosphere, there is the problem that the degree of contamination of an optical component not sealed within an airtight environment can be affected depending upon the operating environment of the product.

Moreover, semiconductor laser elements are themselves problematic in that the problems described above are exacerbated due to the extremely high light density and temperature at the light-emitting facets thereof. In particular, the adherence of silicon compounds in the presence of oxygen is considered a major problem.

### SUMMARY OF THE INVENTION

The present invention was contrived in order to solve the problems described above, it being an object thereof to provide a method for preventing contamination of an optical component not sealed in an airtight environment in an optical module using a short-wavelength, high-output laser element.

In order to achieve the object described above, the optical component according to the present invention emits or transmits laser light of a wavelength of 460 nm or less, and has an aspect (first aspect) such that a first coating formed from a dielectric film is applied upon at least a part of the surface thereof, and a second coating formed from a dielectric film containing a noble metal or platinum group element is applied upon the first coating.

In a preferred aspect (second aspect) of the optical component constituting the first aspect described above, the second coating has a noble metal or platinum group element content of 5 at% or more.

In a preferred aspect (third aspect) of the optical component constituting the first or second aspect described above, the thickness of the second coating is 100 Å or less.

In a preferred aspect (fourth aspect) of the optical component constituting one of the first through third aspects described above, the component is a semiconductor laser element.

In a preferred aspect (fifth aspect) of the optical component constituting one of the first through third aspects described above, the component is a cap glass for a semiconductor laser.

In a preferred aspect (sixth aspect) of the optical component constituting one of the first through third aspects described above, the component is a collimator lens.

In a preferred aspect (seventh aspect) of the optical component constituting one of the first through third aspects described above, the component is a condenser lens.

In a preferred aspect (eighth aspect) of the optical component constituting one of the first through third aspects described above, the component is a beam splitter.

The optical module according to the present invention has a semiconductor laser element mounted within a package and adapted for emitting laser light, a cap glass for guiding laser light emitted by the semiconductor laser element to the outside of the package, a collimator lens for collimating the laser light guided out by the cap glass, a beam splitter for splitting the laser light collimated by the collimator lens, and a condenser lens for condensing the laser light split by the beam splitter; and has a aspect (ninth aspect) such that a first coating made from a dielectric film is applied to at least a part of a surface of at least one of the semiconductor laser element, the cap glass, the collimator lens, the beam splitter, and the condenser lens, and a second coating made from a dielectric film containing a noble metal or platinum group element is applied upon the first coating.

In a preferred aspect (tenth aspect) of the optical module constituting the ninth aspect described above, the semiconductor laser element emits laser light of a wavelength of 460 nm or less.

In accordance with the present invention, it is possible to prevent contamination by organic silicon compounds, hydrocarbon compounds, or the like by modifying the material of the coating of the optical component. It is therefore possible to produce a product with a longer lifespan and higher reliability, even when a source of contamination is present in the operating environment of the product.

Further features, elements, steps, advantages, and characteristics of the present invention will become apparent from the detailed description of the best mode for embodying the invention and the attached drawings relating thereto given below.

### BRIEF DESCRIPTION OF THE DRAWINGS

Fig. 1 is a schematic outline of an optical module according to a first embodiment of the present invention; and
Fig. 2 is a schematic longitudinal sectional view of a nitride semiconductor laser element.

### DETAILED DESCRIPTION OF PREFERRED EMBODIMENTS

### <Prior testing>

Testing by the inventors of an optical component in an optical module using a short-wavelength (405 nm band), high-output (watt-class) nitride semiconductor laser after extended operation prior to the creation of the present invention actually revealed contamination believed to be an adhering substance containing silicon. Because such contamination occurs more readily at shorter wavelengths of laser light, the problem of contamination as described above is believed to readily occur in optical components emitting or transmitting at least laser light of a wavelength of 460 nm (the wavelength of blue light) or less.

Below follows a detailed description, with reference to the drawings, of a specific embodiment of the present invention, created in light of the prior testing described above.

### <Optical module>

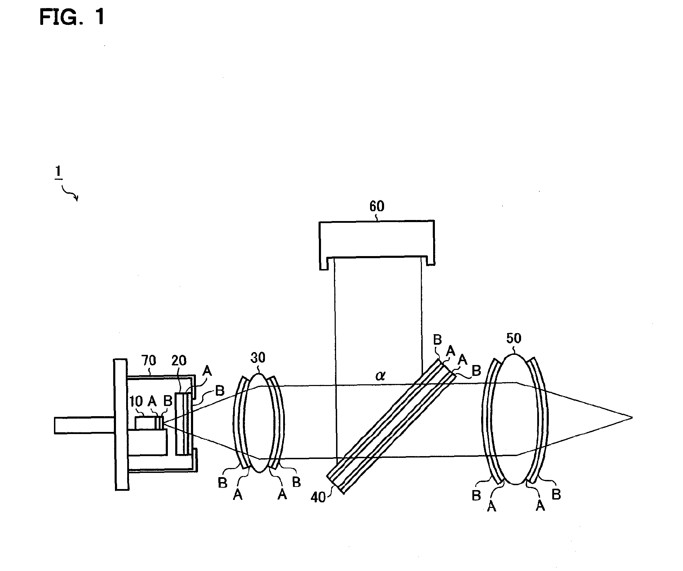

Fig. 1 is a schematic outline of an optical module according to a first embodiment of the present invention. An optical module (semiconductor laser module) 1 according to the present invention has a nitride semiconductor laser element 10, a cap glass 20, a collimator lens 30, a beam splitter 40, a condenser lens 50, a photodiode 60, and a can package 70. The label α in Fig. 1 indicates the state (guidance path) of the laser light generated by the optical module 1. Use of the optical module 1 as a light source for a projector or the like is contemplated.

The nitride semiconductor laser element 10 is one optical component included in the optical module 1, and is mounted within the can package 70 and emits laser light α.

The cap glass 20 is one optical component included in the optical module 1, and guides the laser light α emitted by the nitride semiconductor laser element 10 out of the can package 70.

The collimator lens 30 is one optical component included in the optical module 1, and collimates the laser light α guided by the cap glass 20.

The beam splitter 40 is one optical component included in the optical module 1, and splits the laser light α collimated by the collimator lens 30 into two beams.

The condenser lens 50 is one optical component included in the optical module 1, and condenses the laser light α split by the beam splitter 40.

The photodiode 60 is one optical component included in the optical module 1, and is struck by the laser light α split by the beam splitter 40.

The can package 70 is a canister-shaped member within which is mounted the nitride semiconductor laser element 10.

The optical module 1 having the configuration described above is configured so that the nitride semiconductor laser element 10 (laser light α oscillation wavelength: 405 nm band) mounted inside the can package 70 having the cap glass 20 acts as a laser light source, laser light α collimated by the collimator lens 30 is split toward the condenser lens 50 and the photodiode 60 by the beam splitter 40, and laser light α is focused upon an object of irradiation by the condenser lens 50.

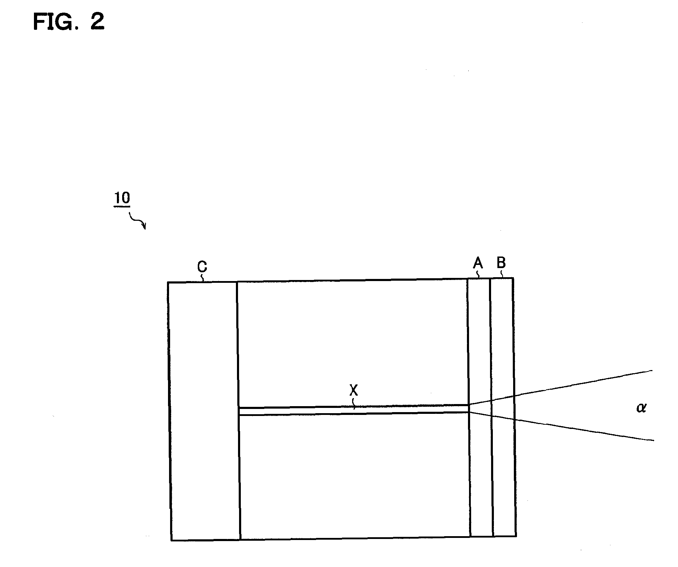

Fig. 2 is a schematic longitudinal sectional view of the nitride semiconductor laser element 10. As shown in Fig. 2, a low-reflectivity layer A (equivalent to the first coating) made from a dielectric film (for example, SiO₂) is formed on the light emitting facet of the nitride semiconductor laser element 10, which emits laser light α from an active layer X, in order to facilitate the transmission of laser light α in the 405 nm band. A contamination prevention layer B (equivalent to the second coating) formed from a dielectric film (for example, SiO₂) to which 5% of a noble metal or platinum group metal (for example, palladium) has been added is formed on a surface of the low-reflectivity layer A in order to suppress contamination (silicon compound adherence) of the light emitting facet. A high-reflectivity layer C formed from a dielectric film (for example, a multiple-layer film of SiO₂ and TiO₂) or a metallic film (for example, aluminum, gold, or silver) is formed on an facet of the nitride semiconductor laser element 10 opposite to the light emitting facet. In cases where a metallic film is used as the high-reflectivity layer C, it is necessary to combine same with a dielectric film as an undercoat in order to prevent shorting between the p-type layer and the n-type layer of the nitride semiconductor laser element 10.

A low-reflectivity layer A and a contamination prevention layer B are also formed in layers on each of the light transmitting surfaces (one surface [the outside surface] of the cap glass 20, both surfaces of the collimator lens 30, both surfaces of the beam splitter 40, and both surfaces of the condenser lens 50) of the other optical components forming the constituent elements of the optical module 1, as shown in Fig. 1.

### <Observations regarding the contamination prevention layer>

The inventors of the present application have discovered that the presence of a noble metal or platinum group metal such as palladium on the outermost surface of an optical component has an effect of suppressing the adherence of silicon compounds, although the mechanism thereof is not clear. Thus, implementing silicon compound adherence prevention measures using a noble metal or platinum group metal on each of the optical components promises high effectiveness in ensuring the reliability of the optical module 1.

In particular, a configuration in which a measure for preventing the adherence of silicon compounds using a noble metal or platinum group metal is implemented on each of the optical components enables contamination to be suppressed regardless of the operating environment of the product, even in optical components that are not sealed airtight. It is believed that silicon compound adherence readily occurs on the light emitting facet of the semiconductor laser element 10 because the light density and temperature become extremely high when the laser light α is being outputted. Thus, contamination such as that described above can be effectively suppressed by implementing silicon compound adherence prevention measures using a noble metal or a platinum group on the light emitting facet of the semiconductor laser element 10.

The structure of the metallic bond also plays a role in absorbing light. Thus, the contamination prevention layer B formed on the outermost surface of each of the optical components is preferably no more than a certain thickness. Contamination prevention effects are believed to be yielded up to about ten atomic layers from the surface layer of the contamination prevention layer B. Thus, the noble metal or platinum group content (concentration) of the contamination prevention layer B is preferably no less than a certain amount.

The above-described contamination prevention effects of the noble metal or platinum group metal can be obtained even when the entire surface of each of the optical components is not covered by the noble metal or platinum group metal. This is believed to be due to the large size of the molecules of siloxane and the like that are the source of contamination, compared to that of the metal atoms. For example, when the contamination prevention layer B has a noble metal or platinum group metal content (concentration) of 5 at%, 50% of the surface upon which the contamination prevention layer B is formed can be described as being covered by the noble metal or platinum group metal. Also, when the noble metal or platinum group metal is evenly distributed within the contamination prevention layer B, alternating gaps of only about the size of one atom are present, promising little purchase for molecules of silicon compounds such as siloxanes to adhere.

Meanwhile, as described previously, the noble metal or platinum group metal forming a metallic bond also serves to absorb light. The light absorption coefficient of the metal material varies according to wavelength, but is approximately from 5×10⁵ cm⁻³ to 1×10⁶ cm⁻³. Therefore, assuming that the light absorption action of the noble metal or platinum group metal contained in the contamination prevention layer B is equivalent to that of pure metal, the light absorption rate of a contamination prevention layer B with a noble metal or platinum group metal content (concentration) of 5 at% and a thickness of 100 Å is from 3 to 5%. When the thickness of the contamination prevention layer B is 50 Å, the contamination prevention layer B has an even smaller light absorption rate of approximately from 1 to 2%, which is advantageous when multiple optical components are incorporated.

On the basis of the above observations, the amount (concentration) of the noble metal or platinum group metal added to the contamination prevention layer B is preferably 5 at% or more, and the thickness of the contamination prevention layer B is preferably 100 Å or less.

In the example given above, SiO₂ was the matrix material of the contamination prevention layer B; however, the matrix material of the contamination prevention layer B is not limited thereto; it may be selected from various dielectric materials including oxides such as Al₂O₃ and Ta₂O₅, nitrides such as SiN and AlN, fluorides such as MgF₂, and so forth. By using these matrix materials, it is possible to easily and precisely manufacture a contamination prevention layer B demonstrating low light absorption and superior contamination prevention effects. Substances added to the matrix material may be selected from the platinum group metals nickel or platinum, apart from palladium as given in the above example, or alternatively from the noble metals gold, silver, iridium, rhodium, osmium, or ruthenium.

### <Method for forming the contamination prevention layer>

Next, a method for forming the contamination prevention layer B will be described with reference to Fig. 1. First, a low-reflectivity layer A is formed upon the surface of the matrix material of the optical components (semiconductor laser element 10, cap glass 20, collimator lens 30, beam splitter 40, and condenser lens 50). The low-reflectivity layer A can be configured as a single or composite layer comprising a combination of from 1 to 3 dielectric films, and may be freely designed in order to yield the desired properties. An electron beam vapor deposition method, sputtering method, or chemical vapor deposition (CVD) method can be employed as the method for forming the dielectric film.

Next, a contamination prevention layer B is formed on the surface of the low-reflectivity layer A described above. An electron beam method or sputtering method can be used as the method for forming the contamination prevention layer B; from considerations of the stability of the film composition, a sputtering method is preferably adopted. In the sputtering method, a target member having the desired composition (for example, SiO₂ containing 5 at% palladium) may be prepared in advance, or a co-sputtering method in which sputtering is performed on a noble metal or platinum group metal (for example, palladium) upon a matrix (for example, SiO₂) may also be adopted.

### <Modifications>

Various modifications within the spirit of the present invention can also be made to the configuration of the present invention apart from the foregoing embodiment.

For example, in the embodiment given above, the example of a configuration in which a low-reflectivity layer A and contamination prevention layer B are formed in layers on each of the light emitting facet of the nitride semiconductor laser element 10, one surface (the outside surface) of the cap glass 20, both surfaces of the collimator lens 30, both surfaces of the beam splitter 40, and both surfaces of the condenser lens 50 was described; however, the configuration of the present invention is not limited to this; a configuration in which the low-reflectivity layer A and contamination prevention layer B are formed in layers upon the other surface (inside surface) of the cap glass 20, the light-receiving surface of the photodiode 60, and the like is also possible.

In cases where the can package 70 is sealed using a highly airtight method after the interior of the can package 70 is first cleaned, almost no siloxanes are present on the inside of the cap glass 20, thereby allowing the provision of the coating formed by the low-reflectivity layer A and contamination prevention layer B on the other surface (inner surface) of the cap glass 20, as described in the above embodiment, to be omitted. In cases where the can package 70 is sealed using a highly airtight method without the interior thereof first being cleaned, or in cases where the can package 70 is sealed using a poorly airtight method, it is preferable to apply the coating formed from the low-reflectivity layer A and contamination prevention layer B not only on one surface (the outer surface) of the cap glass 20 but also on the other surface (the inner surface), as siloxanes can potentially be present within the cap glass 20.

The photodiode 60 normally is a member for monitoring the amount of laser light α, and part of the laser light α shines thereupon. As such, because only small amounts of light shine upon the photodiode 60, the light-receiving surface of the photodiode 60 does not readily increase in temperature, and there is little risk of siloxane degradation products adhering. As such, no particular problems are anticipated even if the coating formed from the low-reflectivity layer A and the contamination prevention layer B is omitted from the light-receiving surface of the photodiode 60. However, when cost is not an issue, it is possible to apply a coating formed from the low-reflectivity layer A and the contamination prevention layer B to the light-receiving surface of the photodiode 60 as well.

### <Industrial Applicability>

The present invention can be used as a technique for preventing contamination of an optical component that has not been sealed airtight in, for example, an optical module using a short-wavelength, high-output laser element.

### LIST OF REFERENCE NUMERALS

- 1: Optical module (semiconductor laser module)
- 10: Nitride semiconductor laser element
- 20: Cap glass
- 30: Collimator lens
- 40: Beam splitter
- 50: Condenser lens
- 60: Photodiode
- 70: Can package
- A: Low-reflectivity layer (first coating)
- B: Contamination prevention layer (second coating)
- C: High-reflectivity layer
- X: Active layer
- α: Laser light

## Claims

1. An optical component comprising:
a first coating made from a dielectric film applied to at least part of a surface of the optical component; and
a second coating made from a dielectric film containing a noble metal or platinum group element applied upon the first coating; wherein:
the optical component emits or transmits laser light of a wavelength of 460 nm or less.

2. The optical component according to claim 1, wherein:
the second coating has a noble metal or platinum group element content of 5 at% or more.

3. The optical component according to claim 1, wherein:
the second coating has a thickness of 100 Å or less.

4. The optical component according to claim 1, wherein:
the optical component is a semiconductor laser element.

5. The optical component according to claim 1, wherein:
the optical component is a cap glass for a semiconductor laser.

6. The optical component according to claim 1, wherein:
the optical component is a collimator lens.

7. The optical component according to claim 1, wherein:
the optical component is a condenser lens.

8. The optical component according to claim 1, wherein:
the optical component is a beam splitter.

9. An optical module comprising:
a semiconductor laser element mounted within a package and adapted for emitting laser light;
a cap glass for guiding laser light emitted by the semiconductor laser element out of the package;
a collimator lens for collimating the laser light guided out by the cap glass;
a beam splitter for splitting the laser light collimated by the collimator lens; and
a condenser lens for condensing the laser light split by the beam splitter; wherein:
a first coating made from a dielectric film is applied to at least part of a surface of at least one of the semiconductor laser element, cap glass, collimator lens, beam splitter, and condenser lens; and
a second coating made from a dielectric film containing a noble metal or platinum group element is applied upon the first coating.

10. The optical component according to claim 9, wherein:
the semiconductor laser element emits laser light of a wavelength of 460 nm or less.
